# EUROPÄISCHE PATENTSCHRIFT

(11) **EP 0 524 378 B1**
(45) Veröffentlichungstag und Bekanntmachung des Hinweises auf die Patenterteilung: **16.08.1995**
(21) Anmeldenummer: 92106597.5
(22) Anmeldetag: 16.04.1992
(51) Int. Cl.: G01R 21/00

(54) **Anordnung zum Messen einer Blindleistung oder einer Blindenergie**
Appliance for measuring the reactive power or -energy
Dispositif pour mesurer la puissance réactive ou l'énergie réactif

(30) Priorität: 22.07.1991 CH 2183/91
(43) Veröffentlichungstag der Anmeldung: 27.01.1993
(73) Patentinhaber: Landis & Gyr Technology Innovation AG, 6301 Zug (CH)
(72) Erfinder: King, Martin, CH-6300 Zug (CH); Döbele, Reinhard, CH-6312 Steinhausen (CH); Rashcle, Ruedi, CH-8820 Wädenswil (CH)

(56) Entgegenhaltungen:
- EP-A- 0 266 488
- US-A- 4 056 774
- PATENT ABSTRACTS OF JAPAN, Band 5, Nr. 185 (P-91)[857], 25. November 1981; & JP-A-56 112 656 (TOUKOU SEIKI K.K.) 05-09-1981
- PATENT ABSTRACTS OF JAPAN, Band 6, Nr. 92 (P-119)[970], 29. Mai 1982; & JP-A-57 26 762 (TOKYO SHIBAURA DENKI K.K.) 12-02-1982

## Beschreibung

Die Erfindung bezieht sich auf eine Anordnung zum Messen einer Blindleistung oder einer Blindenergie gemäss dem Oberbegriff des Anspruchs 1.

Die Anordnung zum Messen der Blindenergie ist vorzugsweise ein Blindenergie-Elektrizitätszähler. Die Anordnung zum Messen der Blindleistung ist z. B. der Eingangsteil eines solchen Blindenergie-Elektrizitätszählers.

Eine Anordnung der im Oberbegriff des Anspruchs 1 genannten Art ist aus der EP 0 266 488 A1 bekannt und enthält unter anderem einen 90°-Phasenschieber.

In der Theorie wird idealerweise meistens angenommen, dass das Ausgangssignal des 90°-Phasenschiebers freqenzunabhängig ist. Im Gegensatz dazu ist das Ausgangssignal von praktisch verwendeten 90°-Phasenschiebern in der Regel frequenzabhängig, so dass auch eine mit seiner Hilfe gemessene Blindleistung oder Blindenergie von der Frequenz einer zur Blindleistung bzw. zur Blindenergie gehörenden elektrischen Wechselspannung abhängig ist, was die Messgenauigkeit der Anordnung negativ beeinflusst, wenn die Frequenz starken Schwankungen unterworfen ist, wie dies z. B. bei Energieversorgungsspannungen oft der Fall ist.

Der Erfindung liegt die Aufgabe zugrunde, eine Anordnung der eingangs genannten Art so zu verbessern, dass deren Messresultat unabhängig von der Frequenz einer zur Blindleistung bzw. zur Blindenergie gehörenden elektrischen Wechselspannung ist und somit eine höhere Messgenauigkeit bei Frequenzschwankungen erzielbar ist.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

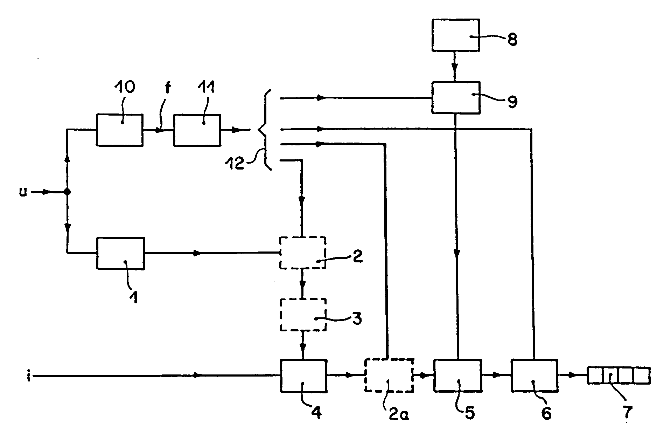

Ausführungsbeispiele der Erfindung sind in der Zeichnung dargestellt und werden im folgenden näher beschrieben.

Die einzige Figur der Zeichnung zeigt vier Varianten der erfindungsgemässen Anordnung. Alle nur fakultativ vorhandenen Bauelemente sind in der Figur gestrichelt dargestellt.

Die erfindungsgemässe Anordnung enthält einen 90°-Phasenschieber 1, eine fakultativ vorhandene erste Multiplizier-Anordnung 2, eine fakultativ vorhandene zweite Multiplizier-Anordnung 2a, eine fakultativ vorhandene Zwischenschaltung 3, einen Multiplizierer 4, einen Signal/Frequenz-Wandler 5, einen Frequenzteiler 6, eine Anzeige 7, einen Taktgenerator 8, einen Taktfrequenzteiler 9, eine Frequenz-Messanordnung 10 und einen Frequenz/Signal-Wandler 11. Die erste Multiplizier-Anordnung 2 ist dabei nur in einer ersten Variante und die zweite Multiplizier-Anordnung 2a nur in einer vierten Variante der erfindungsgemässen Anordnung vorhanden.

Die beiden Multiplizier-Anordnungen 2 und 2a bestehen z. B. je aus einem Hallelement, einem Operations-Transkonduktanz-Verstärker (OTA) oder einem digitalen Multiplizierglied.

Der Multiplizierer 4 besteht z. B. aus einem Impulsamplituden-Modulator, einem mit einer Stromschlaufe versehenen Hallelement oder einem Operations-Transkonduktanz-Verstärker (OTA). Im ersteren Fall ist die Zwischenschaltung 3 ein Impuls-Impulslücken-Modulator ("mark space modulator") und im letzteren Fall ist die Zwischenschaltung 3 überflüssig und nicht vorhanden. Ist der Multiplizierer 4 dagegen ein Hallelement, dann ist die Zwischenschaltung 3 ein Spannungs/Strom-Wandler und besteht vorzugsweise aus einem Reihenwiderstand, der einem ersten Eingang des Multiplizierers 4 vorgeschaltet ist.

Der Eingang des 90°-Phasenschiebers 1 und der Eingang der Frequenz-Messanordnung 10 sind von einem zur Blindleistung bzw. zur Blindenergie gehörenden ersten Signal gespeist. In einer ersten, in der Figur dargestellten Untervariante der ersten Variante, ist der Ausgang des 90°-Phasenschiebers 1 über die erste Multiplizier-Anordnung 2 und die Zwischenschaltung 3, falls vorhanden, ansonsten unmittelbar, auf den ersten Eingang des Multiplizierers 4 geführt, während ein zweiter Eingang des letzteren von einem zur Blindleistung bzw. zur Blindenergie gehörenden zweiten Signal gespeist ist. Das erste Signal ist die zur Blindleistung bzw. zur Blindenergie gehörende Wechselspannung u oder der dazugehörige Wechselstrom i. Das zweite Signal ist dann umgekehrt der zur Blindleistung bzw. zur Blindenergie gehörende Wechselstrom i bzw. die dazugehörige Wechselspannung u. Dabei sind die erste Multiplizier-Anordnung 2 und die Zwischenschaltung 3, falls vorhanden, in der angegebenen Reihenfolge in Kaskade geschaltet. In einer zweiten, in der Figur nicht dargestellten Untervariante der ersten Variante, ist die erste Multiplizier-Anordnung 2 dem zweiten Eingang des Multiplizierers 4 vorgeschaltet, so dass der Ausgang des Phasenschiebers 1 entweder unmittelbar oder über die Zwischenschaltung 3 auf den ersten Eingang des Multiplizierers 4 geführt ist.

Der Multiplizierer 4, falls vorhanden, die zweite Multiplizier-Anordnung 2a, der Signal/Frequenz-Wandler 5 und der Frequenzteiler 6 sind in der angegebenen Reihenfolge in Kaskade geschaltet zwecks Bildung einer Kaskadenschaltung 4;5;6 bzw. 4;2a;5;6, deren Ausgangsignal auf die Anzeige 7 geführt ist. Das Ausgangssignal des Multiplizierers 4 ist bekanntlich proportional der Blindleistung und wird in den drei ersten Varianten im Signal/Frequenz-Wandler 5 in eine proportionale Frequenz rechteckförmiger Impulse umgewandelt, die im Frequenzteiler 6 noch durch einen programmierbaren Wert geteilt wird. Die Ausgangsimpulse des Frequenzteilers 6 werden schliesslich in der Anzeige 7 gezählt und angezeigt.

Der 90°-Phasenschieber 1 besitzt in der Regel, wie bereits erwähnt, einen von der Frequenz f der Wechselspannung u abhängigen Übertragungsfaktor, der nachfolgend mit K[f] bezeichnet wird. Ohne Gegenmassnahmen ist dann auch das in der Anzeige 7 angezeigte Ausgangssignal der Kaskadenschaltung 4;5;6 bzw. 4;2a;5;6 frequenzabhängig.

Der Taktgenerator 8 ist über den Taktfrequenzteiler 9 mit einem Taktsignaleingang des Signal/Frequenz-Wandlers 5 verbunden. Die Frequenz-Messanordnung 10 und der Frequenz/Signal-Wandler 11 sind in der angegebenen Reihenfolge in Kaskade geschaltet.

Die Frequenz-Messanordnung 10 dient dem Messen der Frequenz f der Wechselspannung u und besteht z. B. aus einer nichtdargestellten Kaskadenschaltung eines Komparators, der die sinusförmige Wechselspannung u in ein rechteckförmiges Impulssignal umwandelt, und eines nachgeschalteten Impulszählers, der die Impulse des Impulssignals zählt.

Das Ausgangssignal der Frequenz-Messanordnung 10 und damit auch das Eingangssignal des Frequenz/Signal-Wandlers 11 sind jeweils proportional den gemessenen Werten der Frequenz f. Der Frequenz/Signal-Wandler 11 besitzt seinerseits ein Ausgangssignal, welches in der ersten sowie vierten Variante umgekehrt proportional und in der zweiten sowie dritten Variante proportional dem frequenzabhängigen Übertragungsfaktor K[f] des 90°-Phasenschiebers 1 ist. Der Frequenz/Signal-Wandler 11 besteht vorzugsweise aus einem Festwertspeicher ("Read only memory", ROM), indem tabellenförmig die zu jeder gemessenen Frequenz f der Wechselspannung u gehörenden Werte von 1/K[f] bzw. K[f] gespeichert sind.

In allen vier Varianten der erfindungsgemässen Anordnung ist ein Ausgang des Frequenz/Signal-Wandlers 11 so mit einem Eingang der Kaskadenschaltung 4;5;6 bzw. 4;2a;5;6 verbunden, dass das Ausgangssignal der letzteren unabhängig vom Wert der Frequenz f der Wechselspannung u ist. In der Zeichnung sind die vier Varianten symbolisch durch eine geschweifte Klammer 12 dargestellt, die andeutet, dass der Ausgang des Frequenz/Signal-Wandlers 11 je nach Variante auf einen Eingang der ersten Multiplizier-Anordnung 2, der zweiten Multiplizier-Anordnung 2a, des Frequenzteilers 6 oder des Signal/Frequenz-Wandlers 5 geführt ist.

In der ersten Variante der erfindungsgemässen Anordnung ist die erste Multiplizier-Anordnung 2 vorhanden und einer der beiden Eingänge des Multiplizierers 4 derjenige Eingang der Kaskadenschaltung 4;5;6, der mit dem Ausgang des Frequenz/Signal-Wandlers 11 verbunden ist. Vorzugsweise ist dabei der Ausgang des letzteren mit einem Eingang der Kaskadenschaltung 4;5;6 verbunden, indem er auf einen ersten Eingang der ersten Multiplizier-Anordnung 2 geführt ist und der Ausgang der letzteren mit demjenigen der beiden Eingänge des Multiplizierers 4 verbunden ist, der den Eingang der Kaskadenschaltung 4;5;6 bildet, der mit dem Ausgang des Frequenz/Signal-Wandlers 11 zu verbinden ist. Der Ausgang des 90°-Phasenschiebers 1 ist dann auf einen zweiten Eingang der ersten Multiplizier-Anordnung 2 geführt. In der letzteren wird das Ausgangsignal des 90°-Phasenschiebers 1, welches proportional K[f] ist, mit dem Ausgangssignal des Frequenz/Signal-Wandlers 11 multipliziert, welches in der ersten Variante proportional 1/K[f] ist, so dass das Ausgangssignal der ersten Multiplizier-Anordnung 2 und damit auch das Ausgangssignal der Kaskadenschaltung 4;5;6 frequenzunabhängig wird, da der Faktor K[f] anlässlich der Multiplikation eliminiert wird.

In einer zweiten Variante der erfindungsgemässen Anordnung ist der Ausgang des Frequenz/Signal-Wandlers 11 mit einem Eingang der Kaskadenschaltung 4;5;6 verbunden, indem er auf einen Programmiereingang des Frequenzteilers 6 geführt ist. Das Ausgangssignal des Multiplizierers 4, welches in der zweiten Variante proportional dem Ausgangssignal des 90°-Phasenschiebers 1 und damit proportional K[f] ist, wird im Signal/Frequenz-Wandler 5 in eine proportionale Frequenz umgewandelt, die am Signaleingang des Frequenzteilers 6 ansteht und ebenfalls proportional K[f] ist. Das am Programmiereingang des Frequenzteilers 6 anstehende Signal, also in der zweiten Variante das Ausgangssignal des Frequenz/Signal-Wandlers 11, bestimmt den Wert, mit dem der Frequenzteiler 6 seine Eingangsfrequenz teilt. In der zweiten Variante ist der Programmierwert des Frequenzteilers 6 genau wie dessen Eingangsfrequenz proportional K[f], so dass der Faktor K[f] im Frequenzteiler 6 bei der Frequenzteilung eliminiert und das Ausgangssignal der Kaskadenschaltung 4;5;6 frequenzunabhängig wird.

In einer dritten Variante der erfindungsgemässen Anordnung ist der Ausgang des Frequenz/Signal-Wandlers 11 mit einem Eingang der Kaskadenschaltung 4;5;6 verbunden, indem der Ausgang des Frequenz/Signal-Wandlers 11 auf einen Programmiereingang des Taktfrequenzteilers 9 geführt ist. In der dritten Variante ist dessen Programmierwert proportional K[f] und dessen Ausgangsfrequenz somit proportional 1/K[f]. Die Ausgangsfrequenz des Signal/Frequenz-Wandlers 5 ist dagegen einerseits proportional dem Ausgangssignal des Multiplizierers 4, welches wie in der zweiten Variante proportional K[f] ist, und anderseits proportional der Ausgangsfrequenz des Taktfrequenzteilers 9, welche proportional 1/K[f] ist, so dass K[f] im Signal/Frequenz-Wandler 5 eliminiert wird und das Ausgangssignal der Kaskadenschaltung 4;5;6 frequenzunabhängig wird.

In der vierten Variante der erfindungsgemässen Anordnung ist die zweite Multiplizier-Anordnung 2a vorhanden, deren Ausgangssignal im Signal/Frequenz-Wandler 5 in eine proportionale Frequenz umgewandelt wird. Der Ausgang des Frequenz/Signal-Wandlers 11 ist mit einem Eingang der Kaskadenschaltung 4;2a;5;6 verbunden, indem er auf einen ersten Eingang der zweiten Multiplizier-Anordnung 2a geführt ist, deren zweiter Eingang der Bildung der Kaskadenschaltung 4;2a;5;6 dient. Das Ausgangssignal des Multiplizierers 4, welches wie in der zweiten Variante proportional K[f] ist, wird in der zweiten Multiplizier-Anordnung 2a mit dem Ausgangssignal des Frequenz/Signal-Wandlers 11 multipliziert, welches in der vierten Variante proportional 1/K[f] ist, so dass das Ausgangssignal der zweiten Multiplizier-Anordnung 2a und damit auch das Ausgangssignal der Kaskadenschaltung 4;2a;5;6 frequenzunabhängig wird, da der Faktor K[f] anlässlich der Multiplikation eliminiert wird.

In allen vier Varianten der erfindungsgemässen Anordnung ist somit das Ausgangssignal der Kaskadenschaltung 4;5;6 bzw. 4;2a;5;6 und damit auch das Messresultat der Anordnung frequenzunabhängig, so dass die Messgenauigkeit der Anordnung nicht mehr negativ durch die Werte der Frequenz f beeinflusst werden kann.

## Patentansprüche

1. Anordnung zum Messen einer Blindleistung oder einer Blindenergie mit einem Multiplizierer (4), einem Signal/Frequenz-Wandler (5) und einem Frequenzteiler (6), die in der angegebenen Reihenfolge in Kaskade geschaltet sind zwecks Bildung einer Kaskadenschaltung (4;5;6 bzw. 4;2a;5;6), deren Ausgangssignal auf eine Anzeige (7) geführt ist, sowie einem 90°-Phasenschieber (1), dessen Eingang von einer zur Blindleistung bzw. zur Blindenergie gehörenden Wechselspannung (u) bzw. Wechselstrom (i) als erstem Signal gespeist und dessen Ausgang auf einen ersten Eingang des Multiplizierers (4) geführt ist, während ein zweiter Eingang des Multiplizierers (4) von einem zur Blindleistung bzw. zur Blindenergie gehörenden Wechselstrom (i) bzw. Wechselspannung (u) als zweitem Signal gespeist ist, dadurch gekennzeichnet, dass eine Frequenz-Messanordnung (10) zum Messen einer Frequenz (f) der Wechselspannung (u) und ein Frequenz/Signal-Wandler (11) vorhanden sind, die in der angegebenen Reihenfolge in Kaskade geschaltet sind, dass der Frequenz/Signal-Wandler (11) ein Ausgangssignal besitzt, welches proportional oder umgekehrt proportional einem Übertragungsfaktor (K[f]) des 90°-Phasenschiebers (1) ist, und dass ein Ausgang des Frequenz/Signal-Wandlers (11) so mit einem Eingang der Kaskadenschaltung (4;5;6 bzw. 4;2a;5;6) verbunden ist, dass das Ausgangssignal der Kaskadenschaltung (4;5;6 bzw. 4;2a;5;6) unabhängig vom Wert der Frequenz (f) der Wechselspannung (u) ist.

2. Anordnung nach Anspruch 1, dadurch gekennzeichnet, dass einer der beiden Eingänge des Multiplizierers (4) derjenige Eingang der Kaskadenschaltung (4;5;6) ist, der mit dem Ausgang des Frequenz/Signal-Wandlers (11) verbunden ist, und dass das Ausgangssignal des Frequenz/Signal-Wandlers (11) umgekehrt proportional dem Übertragungsfaktor (K[f]) des 90°-Phasenschiebers (1) ist.

3. Anordnung nach Anspruch 2, dadurch gekennzeichnet, dass der Ausgang des Frequenz/Signal-Wandlers (11) auf einen Eingang der Kaskadenschaltung (4;5;6) geführt ist, indem er mit einem ersten Eingang einer Multiplizier-Anordnung (2) verbunden ist, deren zweiter Eingang auf einen Ausgang des 90°-Phasenschiebers (1) und deren Ausgang auf denjenigen der beiden Eingänge des Multiplizierers (4) geführt ist, der den Eingang der Kaskadenschaltung (4;5;6) bildet, der mit dem Ausgang des Frequenz/Signal-Wandlers (11) verbunden ist.

4. Anordnung nach Anspruch 1, dadurch gekennzeichnet, dass der Ausgang des Frequenz/Signal-Wandlers (11) mit einem Eingang der Kaskadenschaltung (4;5;6) verbunden ist, indem er auf einen Programmiereingang des Frequenzteilers (6) geführt ist, und dass das Ausgangssignal des Frequenz/Signal-Wandlers (11) proportional dem Übertragungsfaktor (K[f]) des 90°-Phasenschiebers (1) ist.

5. Anordnung nach Anspruch 1, dadurch gekennzeichnet, dass ein Taktgenerator (8) über einen Taktfrequenzteiler (9) mit einem Taktsignaleingang des Signal/Frequenz-Wandlers (5) verbunden ist, dass der Ausgang des Frequenz/Signal-Wandlers (11) mit einem Eingang der Kaskadenschaltung (4;5;6) verbunden ist, indem er auf einen Programmiereingang des Taktfrequenzteilers (9) geführt ist, und dass das Ausgangssignal des Frequenz/Signal-Wandlers (11) proportional dem Übertragungsfaktor (K[f]) des 90°-Phasenschiebers (1) ist.

6. Anordnung nach Anspruch 1, dadurch gekennzeichnet, dass der Ausgang des Frequenz/Signal-Wandlers (11) mit einem Eingang der Kaskadenschaltung (4;2a;5;6) verbunden ist, indem er auf einen ersten Eingang einer Multiplizier-Anordnung (2a) geführt ist, deren zweiter Eingang der Bildung der Kaskadenschaltung (4;2a;5;6) dient, in der der Multiplizierer (4), die Multiplizier-Anordnung (2a), der Signal/Frequenz-Wandler (5) und der Frequenzteiler (6) in der angegebenen Reihenfolge in Kaskade geschaltet sind, und dass das Ausgangssignal des Frequenz/Signal-Wandlers (11) umgekehrt proportional dem Übertragungsfaktor (K[f]) des 90°-Phasenschiebers (1) ist.

## Claims

1. An arrangement for measuring a reactive power or a reactive energy comprising a multiplier (4), a signal-frequency converter (5) and a frequency divider (6) which are connected in cascade relationship in the specified sequence for the purposes of forming a cascade circuit (4; 5; 6 or 4; 2a; 5; 6 respectively) whose output signal is taken to a display (7), and a 90° phase shifter (1) whose input is fed by an ac voltage (u) or alternating current (i) associated with the reactive power or the reactive energy respectively as a first signal and whose output is taken to a first input of the multiplier (4) while a second input of the multiplier (4) is fed by an alternating current (i) or an ac voltage (u) respectively associated with the reactive power or the reactive energy as a second signal, characterised in that there are a frequency measuring arrangement (10) for measuring a frequency (f) of the ac voltage (u) and a frequency-signal converter (11) which are connected in cascade relationship in the specified sequence, that the frequency-signal converter (11) has an output signal which is proportional or inversely proportional to a transfer factor (K[f]) of the 90° phase shifter (1) and that an output of the frequency-signal converter (11) is so connected to an input of the cascade circuit (4; 5; 6 or 4; 2a; 5; 6 respectively) that the output signal of the cascade circuit (4; 5; 6 or 4; 2a; 5; 6 respectively) is independent of the value of the frequency (f) of the ac voltage (u).

2. An arrangement according to claim 1 characterised in that one of the two inputs of the multiplier (4) is that input of the cascade circuit (4; 5; 6), that is connected to the output of the frequency-signal converter (11), and that the output signal of the frequency-signal converter (11) is inversely proportional to the transfer factor (K[f]) of the 90° phase shifter (1).

3. An arrangement according to claim 2 characterised in that the output of the frequency-signal converter (11) is taken to an input of the cascade circuit (4; 5; 6) by being connected to a first input of a multiplier arrangement (2) whose second input is taken to an output of the 90° use shifter (1) and whose output is taken to that one of the two inputs of the multiplier (4), that forms the input of the cascade circuit (4; 5; 6), which is connected to the output of the frequency-signal converter (11).

4. An arrangement according to claim 1 characterised in that the output of the frequency-signal converter (11) is connected to an input of the cascade circuit (4; 5; 6) by being taken to a programming input of the frequency divider (6), and that the output signal of the frequency-signal converter (11) is proportional to the transfer factor (K[f]) of the 90° phase shifter (1).

5. An arrangement according to claim 1 characterised in that a clock generator (8) is connected to a clock signal input of the signal-frequency converter (5) by way of a clock frequency divider (9), that the output of the frequency-signal converter (11) is connected to an input of the cascade circuit (4; 5; 6) by being taken to a programming input of the clock frequency divider (9), and that the output signal of the frequency-signal converter (11) is proportional to the transfer factor (K[f]) of the 90° phase shifter (1).

6. An arrangement according to claim 1 characterised in that the output of the frequency-signal converter (11) is connected to an input of the cascade circuit (4; 2a; 5; 6) by being taken to a first input of a multiplier arrangement (2a) whose second input serves for the formation of the cascade circuit (4; 2a; 5; 6) in which the multiplier (4), the multiplier arrangement (2), the signal-frequency converter (5) and the frequency divider (6) are connected in cascade relationship in the specified sequence, and that the output signal of the frequency-signal converter (11) is inversely proportional to the transfer factor (K[f]) of the 90° phase shifter (1).

## Revendications

1. Dispositif pour mesurer une puissance réactive ou une énergie réactive, comportant un multiplicateur (4), un convertisseur signal/fréquence (5) et un diviseur de fréquence (6), qui sont connectés en cascade dans la séquence indiquée en vue de former un circuit en cascade (4 ; 5 ; 6 ou 4 ; 2a ; 5 ; 6), dont le signal de sortie est appliqué à un indicateur (7), ainsi qu'un déphaseur de 90° (1), dont l'entrée reçoit comme premier signal une tension (u) ou une intensité (i) du courant alternatif affecté par puissance réactive ou énergie réactive et dont la sortie est reliée à une première entrée du multiplicateur (4), tandis qu'une seconde entrée du multiplicateur (4) reçoit un second signal constitué par une intensité (i) ou une tension (u) du couran alternatif affecté par puissance réactive l'énergie réactive, caractérisé en ce qu'il est prévu un élément de mesure de fréquence (10) pour mesurer une fréquence (f) de la tension alternative (u) et un convertisseur fréquence/signal (11), qui sont connectés en cascade dans la séquence indiquée, en ce que le convertisseur fréquence/signal (11) produit un signal de sortie qui est proportionnel ou inversement proportionnel à un facteur de transmission (K[f]) du déphaseur de 90° (1) et en ce qu'une sortie du convertisseur fréquence/signal (11) est reliée à une entrée du circuit en cascade (4 ; 5 ; 6 ou 4; 2a ; 5 ; 6) de telle sorte que le signal de sortie du circuit en cascade (4 ; 5 ; 6 ou 4 ; 2a ; 5 ; 6) soit indépendant de la valeur de la fréquence (f) de la tension alternative (u).

2. Dispositif selon la revendication 1, caractérisé en ce qu'une des deux entrées du multiplicateur (4) est reliée à l'entrée du circuit en cascade (4 ; 5 ; 6) qui est reliée à la sortie du convertisseur fréquence/signal (11) et en ce que le signal de sortie du convertisseur fréquence/signal (11) est inversement proportionnel au facteur de transmission (K[f]) du déphaseur de 90° (1).

3. Dispositif selon la revendication 2, caractérisé en ce que la sortie du convertisseur fréquence/signal (11) est reliée à une entrée du circuit en cascade (4 ; 5 ; 6) par le fait qu'elle est en liaison avec une première entrée d'un multiplicateur (2), dont la seconde entrée est reliée à une sortie du déphaseur de 90° (1) et dont la sortie est reliée à celle des deux entrées du multiplicateur (4) qui constitue l'entrée du circuit en cascade (4 ; 5 ; 6), qui est reliée à la sortie du convertisseur fréquence/signal (11).

4. Dispositif selon la revendication 1, caractérisé en ce que la sortie du convertisseur fréquence/signal (11) est reliée à une entrée du circuit en cascade (4 ; 5 ; 6) par le fait qu'elle est en liaison avec une entrée de programmation du diviseur de fréquence (6) et en ce que le signal de sortie du convertisseur fréquence/signal (11) est proportionnel au facteur de transmission (K[f]) du déphaseur de 90° (1).

5. Dispositif selon la revendication 1, caractérisé en ce qu'un générateur d'horloge (8) est relié, par l'intermédiaire d'un diviseur de fréquence d'horloge (9), à une entrée de signaux d'horloge du convertisseur signal/fréquence (5), en ce que la sortie du convertisseur fréquence/signal (11) est reliée à une entrée du circuit en cascade (4 ; 5 ; 6) par le fait qu'elle est en liaison avec une entrée de programmation du diviseur de fréquence d'horloge (9), et en ce que le signal de sortie du convertisseur fréquence/signal (11) est proportionnel au facteur de transmission (K[f]) du déphaseur de 90° (1).

6. Dispositif selon la revendication 1, caractérisé en ce que la sortie du convertisseur fréquence/signal (11) est reliée à une entrée du circuit en cascade (4 ; 2a ; 5 ; 6) par le fait qu'elle est en liaison avec une première entrée d'un multiplicateur (2a) dont la seconde entrée sert à former le circuit en cascade (4 ; 2a ; 5 ; 6), où le multiplicateur (4), le multiplicateur (2a), le convertisseur signal/fréquence (5) et le diviseur de fréquence (6) sont connectés en cascade dans la séquence indiquée, et en ce que le signal de sortie du convertisseur de fréquence/signal (11) est inversement proportionnel au facteur de transmission (K[f]) du déphaseur de 90° (1).
